Europäisches Patentamt

European Patent Office

Office européen des brevets

(11) Veröffentlichungsnummer: **0 389 749**

**A2**

# EUROPÄISCHE PATENTANMELDUNG

(21) Anmeldenummer: **90101576.8**

(51) Int. Cl.5: **G01R 21/127**

(22) Anmeldetag: **26.01.90**

(30) Priorität: **31.03.89 CH 1185/89**

(43) Veröffentlichungstag der Anmeldung:
**03.10.90 Patentblatt 90/40**

(84) Benannte Vertragsstaaten:
**CH DE ES FR GB IT LI NL**

(71) Anmelder: **Landis & Gyr Betriebs AG**

**CH-6301 Zug(CH)**

(72) Erfinder: **Halder, Mathis**
**Burgmatt 28b**
**CH-6340 Baar(CH)**
Erfinder: **Wagner, Friedrich Ernst, Dr.**
**Sonnenhofstrasse 1**
**CH-6340 Baar(CH)**
Erfinder: **Frutiger, Theo**
**Kirchmattstrasse 28**
**CH-6312 Steinhausen(CH)**

(54) **Anordnung zum Messen einer elektrischen Leistung oder Energie.**

(57) Die Anordnung enthält pro Phase jeweils einen stromgespeisten Transformator (10) und einen Spannungseingang (18), die beide mit einem zugehörigen, nachgeschalteten und pro Phase vorhandenen Impulsbreiten-Impulslücken-Impulsamplituden-Modulator (13;14) verbunden sind, der jeweils aus einem Impulsbreiten-Impulslücken-Modulator (13) und einem Impulsamplituden-Modulator (14) besteht. Jeder Transformator (10) ist über einen einen hochohmigen Eingang aufweisenden Integrator (11) mit dem Impulsbreiten-Impulslücken-Impulsamplituden-Modulator (13;14) verbunden. Der Impulsamplituden-Modulator (14) weist zwei in Gegentakt betriebene Ausgänge auf, die je auf einen Eingang einer Anordnung zum Integrieren der Flächen von Impulsen und Impulslücken geführt sind, die im Betrieb am Ausgang des Impulsamplituden-Modulators (14) vorhanden sind. Weiterhin sind ausserdem noch vorhanden ein Phasenschieber (12), ein Widerstand (15a), ein VDR-Widerstand (15b) und ein Kondensator (15c). Eine Aufbereitungs- und Anzeigeeinrichtung (4;5;6;7;8) besteht aus einem Strom/Frequenz-Wandler (4), einem Frequenzteiler (5), einer Anpassschaltung (6), einer Anzeige (7) und einer Leuchtdiode (8). Von den beiden gezeichneten Phasenschiebern (12) ist jeweils immer nur einer vorhanden. Der Strom/Frequenz-Wandler (4) enthält die mittels eines Operationsverstärkers (25) aufgebaute Anordnung zum Integrieren der Flächen, vier Schalter (21, 21a, 22, 22a), zwei Stromquellen (23, 23a) und eine Logikschaltung (24). Die Anordnung ist wirtschaftlich und kann unter Verwendung handelsüblicher Bauelemente und einer kundenspezifischen integrierten Schaltung aufgebaut werden, die alle Halbleiterbauelemente enthält.

Fig. 1

## Anordnung zum Messen einer elektrischen Leistung oder Energie

Die Erfindung bezieht sich auf eine Anordnung zum Messen einer elektrischen Leistung oder Energie gemäss dem Oberbegriff des Anspruchs 1.

Es ist eine Anordnung der im Oberbegriff des Anspruchs 1 genannten Art bekannt aus der US-PS 3 602 843, bei dem u. a. ein Impulsbreiten-Impulslücken-Impulsamplituden-Modulator verwendet wird, dessen Aufbau und Arbeitsweise dort ausführlich beschrieben ist.

Der Erfindung liegt die Aufgabe zugrunde, die bekannte Anordnung wirtschaftlich und möglichst unter Verwendung handelsüblicher Bauelemente zu verbessern sowie zu optimieren, wobei möglichst alle Halbleiterbauelemente in einer integrierten Schaltung, insbesondere in einer kundenspezifischen integrierten Schaltung enthalten sind.

Die genannte Aufgabe wird erfindungsgemäss durch die im Kennzeichen des Anspruchs 1 angegebenen Merkmale gelöst.

Vorteilhafte Ausgestaltungen· der Erfindung ergeben sich aus den Unteransprüchen.

Ausführungsbeispiele der Erfindung sind in der Zeichnung dargestellt und werden im folgenden näher beschrieben.

Es zeigen:

Fig. 1 ein Blockschaltbild einer ersten Variante einer erfindungsgemässen Anordnung,

Fig. 2 ein Schaltbild eines Integrators,

Fig. 3 ein Schaltbild einer ersten Variante eines aktiven Phasenschiebers,

Fig. 4 ein Schaltbild einer zweiten Variante eines aktiven Phasenschiebers,

Fig. 5 ein Schaltbild eines passiven Phasenschiebers,

Fig. 6 ein Blockschaltbild einer zweiten Variante einer erfindungsgemässen Anordnung,

Fig. 7 ein Blockschaltbild einer dritten Variante einer erfindungsgemässen Anordnung,

Fig. 8 ein Blockschaltbild einer vierten Variante einer erfindungsgemässen Anordnung,

Fig. 9 ein Schaltbild einer Logikschaltung und

Fig.10 Zeitdiagramme von Taktsignalen.

Gleiche Bezugszahlen bezeichnen in allen Figuren der Zeichnung gleiche Teile.

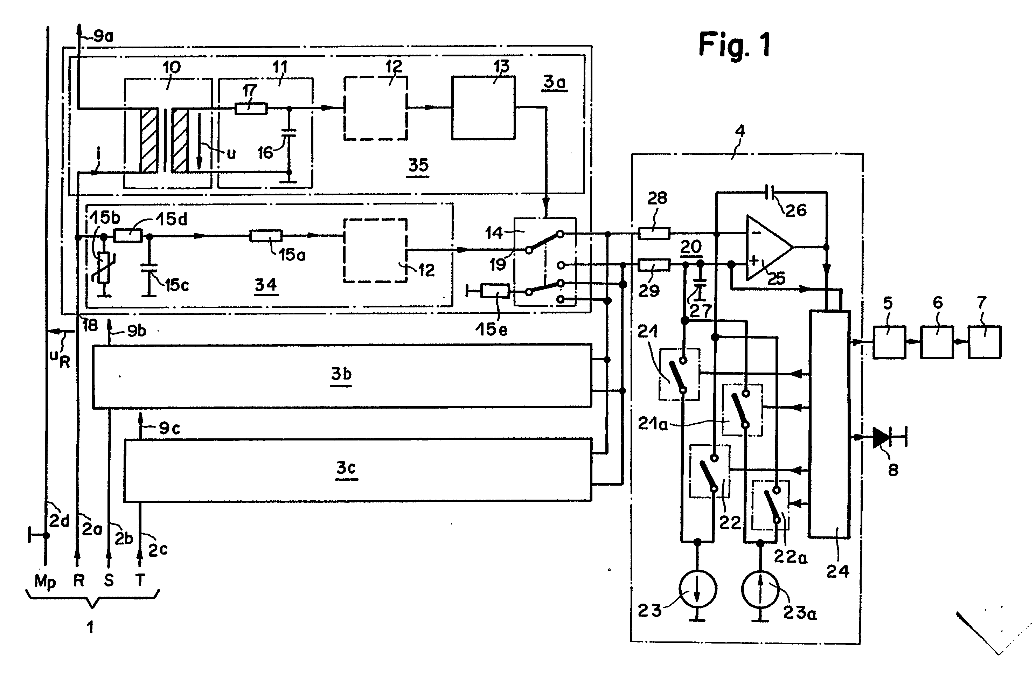

Die in der Fig. 1 dargestellte Anordnung ist ein Dreiphasen-Elektrizitätszähler und wird von einem elektrischen Energieversorgungsnetz 1 über drei Leiter 2a, 2b und 2c mit den drei Phasen R, S und T einer Dreiphasenspannung und über einen vierten Leiter 2d mit einem Massepotential Mp gespeist. Pro Phase ist eine Eingangsschaltung 3a, 3b bzw. 3c vorhanden, die alle drei gleich aufgebaut sind und deren Ausgänge auf einen gemeinsamen Strom/Frequenz-Wandler 4 geführt sind. Ein erster Ausgang des Strom/Frequenz-Wandlers 4 ist auf eine Kaskadenschaltung 5;6;7 geführt, die in der angegebenen Reihenfolge aus einem Frequenzteiler 5, einer Anpassschaltung 6 und einer Anzeige 7 besteht. Fakultativ ist eine Leuchtdiode 8 vorhanden, deren Anode z. B. mit einem zweiten Ausgang des Strom/Frequenz-Wandlers 4 verbunden ist, während deren Kathode z. B. an Masse liegt. Bei einer genügend tiefen Frequenz des zugehörigen Ausgangssignals des Strom/Frequenz-Wandlers 4 kann die Leuchtdiode 8 auch durch ein Relais ersetzt werden. In diesem Fall ist der optische Augang der Leuchtdiode 8 durch einen elektromechanischen Relaiskontaktausgang ersetzt. Die Anpassschaltung 6 besteht z. B. aus einem Schrittmotor mit zugehöriger Interfaceschaltung. In diesem Fall besteht die Anzeige 7 vorzugsweise aus einem mechanischen Impulszählwerk. Die Anzeige 7 kann natürlich auch ein mit Leuchtdioden oder Flüssigkristallen aufgebauter sogenannter "Display" sein. Der Strom/Frequenz-Wandler 4, der Frequenzteiler 5, die Anpassschaltung 6, die Anzeige 7 und die Leuchtdiode 8 bilden zusammen am Ausgang des Elektrizitätszählers eine Aufbereitungs- und Anzeigeeinrichtung 4;5;6;7;8.

Die Leiter 2a, 2b und 2c sind in der ihnen zugehörigen Eingangsschaltung 3a bzw. 3b bzw. 3c jeweils mit einem Pol einer Primärwicklung verbunden, deren anderer Pol jeweils mit einem Leiter 9a bzw. 9b bzw. 9c verbunden ist, der die zugehörige Eingangsschaltung 3a bzw. 3b bzw. 3c und damit den Elektrizitätszähler verlässt, um eine zugehörige, nicht mehr dargestellte Last zu speisen. Die Primärwicklung ist ein Teil eines pro Phase vorhandenen stromgespeisten Transformators 10, der ausserdem noch eine Sekundärwicklung und einen ferromagnetischen Kern aufweist.

In der Fig. 1 ist aus Gründen der zeichnerischen Einfachheit nur der Inhalt einer der drei Eingangsschaltungen, nämlich derjenige der Eingangsschaltung 3a dargestellt.

Das Energieversorgungsnetz 1 kann auch einphasig sein. In diesem Fall sind die Leiter 2b, 2c, 9b und 9c sowie die Eingangsschaltungen 3b und 3c nicht vorhanden und der Elektrizitätszähler ist ein Einphasen-Elektrizitätszähler.

Jede Eingangsschaltung 3a, 3b und 3c besteht aus dem Transformator 10, einem Integrator 11 mit hochohmigem Eingang, einem fakultativ vorhandenen Phasenschieber 12, einem Impulsbreiten-Impulslücken-Modulator 13, einem Impulsamplituden-Modulator 14, einem Widerstand 15a, einem spannungsabhängigen VDR-Widerstand 15b, einem Widerstand 15d, einem Widerstand 15e und einem Kondensator 15c. Der Impulsbreiten-Impulslücken-Modulator 13 und der diesem nachgeschalteten Impulsamplituden-Modulator 14 bilden zusammen einen Impulsbreiten-Impulslücken-Impulsamplituden-Modulator 13;14, wobei der Ausgang des Impuls breiten-Impulslücken-Modulators 13 auf einen Steuereingang des Impulsamplituden-Modulators 14 geführt ist, der vorzugsweise aus einem zweipoligen, zwei Stellungen aufweisenden Umschalter besteht. Der Steuereingang des Umschalters stellt dann den Steuereingang des Impulsamplituden-Modulators 14 dar.

Dem Transformator 10 ist der Integrator 11 nachgeschaltet, d. h. die beiden Ausgangspole des Transformators 10 sind mit den beiden Eingangspolen des Integrators 11 verbunden. Der letzte ist vorzugsweise ein RC-Tiefpassfilter und besteht dann aus einem Kondensator 16 sowie aus mindestens einem Widerstand 17, die zusammen ein RC-Glied 16;17 bilden. Der gemeinsame Pol des Kondensators 16 und des Widerstandes 17 bildet einen einpoligen Ausgang des Integrators 11, während der andere Pol des Widerstandes 17 einen ersten Eingangspol des Integrators 11 und der andere Pol des Kondensators 16, der an Masse liegt, einen zweiten Eingangspol des Integrators 11 bildet.

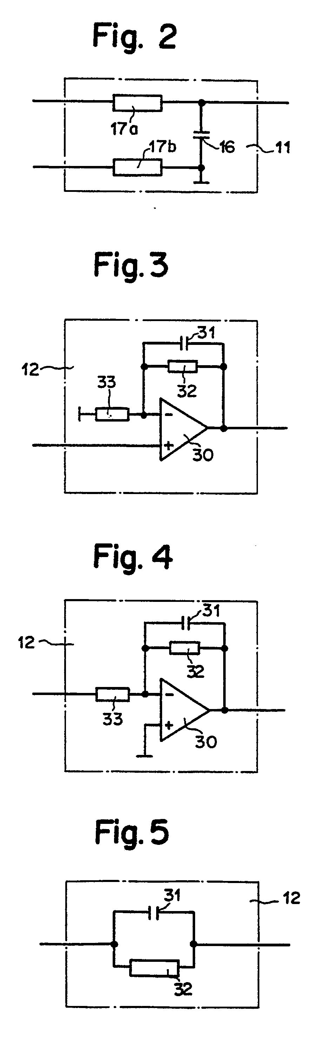

Das RC-Tiefpassfilter kann aber auch in einer bevorzugten Aufbauweise den in der Fig. 2 dargestellten Aufbau besitzen, in dem zwei Widerstände 17a und 17b vorhanden sind, die je zwischen einem der beiden Eingangspole des Integrators 11 und einem der beiden Pole des Kondensators 16 angeordnet sind, wobei ein Pol des letzteren wieder an Masse liegt und der andere Pol wieder den Ausgang des Integrators 11 bildet. Da die beiden Ausgangspole des Transformators 10 mit den zwei Eingangspolen des Integrators 11 verbunden sind (siehe Fig. 1), sind auch die beiden Widerstände 17a und 17b in Reihe zu je einem der beiden Ausgangspole des Transformators 10 angeordnet. Die Summe der Widerstandswerte der beiden Widerstände 17a und 17b ist gleich dem Wert des Widerstandes 17 zu wählen.

Der einpolige Ausgang des Integrators 11 ist unmittelbar oder mittelbar mit einem Eingang des Impulsbreiten-Impulslücken-Modulators 13 verbunden, der gleichzeitig ein erster Eingang des Impulsbreiten-Impulslücken-Impulsamplituden-Modulators 13;14 ist.

Ist der nur fakultativ vorhandene Phasenschieber 12 vorhanden, dann ist er entweder zwischen dem Integrator 11 und dem ersten Eingang des Impulsbreiten-Impulslücken-Impulsamplituden-Modulators 13;14 angeordnet oder er ist einem Spannungseingang 18 des Elektrizitätszählers nachgeschaltet, der dann über den Phasenschieber 12 auf einen Amplitudeneingang 19 des Impulsamplituden-Modulators 14 geführt ist. Dieser Amplitudeneingang 19 ist gleichzeitig ein zweiter Eingang, nämlich der Amplitudeneingang des Impulsbreiten-Impulslücken-Impulsamplituden-Modulators 13;14. Der Widerstand 15a ist im ersten Fall dem Amplitudeneingang 19 und im zweiten Fall dem Phasenschieber 12 unmittelbar vorgeschaltet.

Der pro Phase vorhandene Transformator 10 und der ebenfalls pro Phase vorhandene Spannungseingang 18 sind somit beide mit dem zugehörigen, nachgeschalteten und ebenfalls pro Phase vorhandenen Impulsbreiten-Impulslücken-Impulsamplituden-Modulator 13;14 verbunden.

Innerhalb der Eingangsschaltung 3a, 3b bzw. 3c liegt jeweils zwischen dem Spannungseingang 18 und Masse der spannungsabhängige VDR-Widerstand 15b ("voltage drop resistance") und eine Reihenschaltung 15d;15c, die somit parallelgeschaltet sind und den Spannungseingang 18 gegen Überspannungen und Stossspannungen des Energieversorgungsnetzes 1 schützen. Die Reihenschaltung 15d;15c besteht in der angegebenen Reihenfolge aus dem Widerstand 15d und dem Kondensator 15c, wobei deren gemeinsamer Verbindungspunkt über den Widerstand 15a mit dem Amplitudeneingang 19 des Impulsamplituden-Modulators 14 mittelbar oder unmittelbar verbunden ist.

Der im Impulsamplituden-Modulator 14 enthaltene Umschalter schaltet im Rhythmus der an seinem Steuereingang anstehenden Impulse den Amplitudeneingang 19 des Impulsamplituden-Modulators 14 sowie einen Pol des Widerstandes 15e abwechselnd auf einem der beiden in Gegentakt betriebenen Ausgänge des Impulsamplituden-Modulators 14, die gleichzeitig zwei Ausgänge des Impulsbreiten-Impulslücken-Impulsamplituden-Modulators 13;14 sind. Der zweite Pol des Widerstandes 15e liegt an Masse. Die beiden Ausgänge des Impulsamplituden-Modulators 14 sind auf je einen von zwei Eingängen eines Differentialintegrators 20 geführt, der im Strom/Frequenz-Wandler 4 enthalten ist.

Der Strom/Frequenz-Wandler 4 besteht aus dem Differentialintegrator 20, vier einpoligen Schaltern 21, 21a, 22 und 22a, zwei Stromquellen 23 und 23a sowie einer Logikschaltung 24. Der Differentialintegrator 20 besteht seinerseits aus einem Operationsverstärker 25, zwei Kondensatoren 26 und 27 sowie zwei Widerständen 28 und 29. In der Zeichnung sind die vier Schalter 21, 21a, 22 und 22a aus Gründen der zeichnerischen Einfachheit als einpolige Ein/Aus-Schalter dargestellt, um ihre prinzipielle Funktionsweise, nämlich das Ein/Aus-Schalten der Stromquelle 23 bzw. 23a anzudeuten. Jeder Fachmann weiss jedoch, dass in der Praxis der Strom einer Stromquelle nicht einfach abgeschaltet werden kann wie bei einer Spannungsquelle, sondern dass die Stromquelle gleichzeitig unmittelbar oder mittelbar kurzgeschlossen werden muss. Zu diesem Zweck besteht dann jeder Schalter 21, 21a, 22 und 22a aus einem einpoligen Umschalter, dessen Arbeitskontakt ("normally open contact") die Rolle des Ein/Aus-Schalters übernimmt, während dessen Ruhekontakt ("normally closed contact") die zugehörige Stromquelle 23 bzw. 23a kurzschliesst.

Je ein erster Pol der beiden Widerstände 28 und 29 bildet je einen der beiden Eingänge des Differentialintegrators 20, die gleichzeitig die beiden Eingänge des Strom/Frequenz-Wandlers 4 bilden. Diese beiden Eingänge des Differentialintegrators 20 sind innerhalb desselben jeweils über den Widerstand 28 bzw. 29 mit dem invertierenden bzw. mit dem nichtinvertierenden Eingang des Operationsverstärkers 25 verbunden, dessen Ausgang ein erster Ausgang des Differentialintegrators 20 ist, während der nichtinvertierende Eingang des Operationsverstärkers 25 einen zweiten Ausgang desselben bildet. Der Kondensator 26 ist zwischen dem Ausgang des Operationsverstärkers 25 und dessem invertierenden Eingang angeordnet, während der Kondensator 27 zwischen dem nichtinvertierenden Eingang des Operationsverstärkers 25 und der Masse liegt.

Der erste Ausgang des Differentialintegrators 20 ist mit einem ersten Eingang und sein zweiter Ausgang mit einem zweiten Eingang jeweils der Logikschaltung 24 verbunden, deren beide Signalausgänge die beiden Ausgänge des Strom/Frequenz-Wandlers 4 bilden. Vier Steuerausgänge der Logikschaltung 24 sind mit einem Steuereingang je eines der vier Schalter 21, 22, 21a bzw. 22a verbunden, wobei die beiden ersten Schalter 21 und 22 einen Pol der Stromquelle 23 und die beiden letzten Schalter 21a und 22a einen Pol der Stromquelle 23a mit dem nichtinvertierenden bzw. mit dem invertierenden Eingang des Operationsverstärkers 25 verbinden. Der andere Pol der beiden Stromquellen 23 und 23a liegt jeweils an Masse. Die beiden Stromquellen 23 und 23a sind in entgegengesetzter Richtung gepolt und dienen je nach Stromrichtung der Eingangssignale des Differentialintegrators 20 dem Entladen des Kondensators 27 bzw. 26.

Die Aufgabe der Schaltung 21;22;21a;22a;23;23a;24 ist es, die integrierten Spannungen an den Ausgängen des Differentialintegrators 20 jeweils in eine proportionale Anzahl Impulse pro Zeiteinheit umzuwandeln, wobei jeder Impuls eine konstante Quantität Energie darstellt. Damit die Ausgangsspannungen des Differentialintegrators 20 im Laufe der Zeit nicht ins Unendliche ansteigen, geschieht die Impulserzeugung so, dass beim Erreichen einer bestimmten Energiequantität jeweils eine entsprechende Ladungsquantität mit Hilfe der Stromquelle 23 bzw. 23a und der Schalter 21 und 22 bzw. 21a und 22a vom Ladungsinhalt des Kondensators 27 bzw. 26 subtrahiert wird unter gleichzeitiger Erzeugung eines Impulses an mindestens einem der Ausgänge des Strom/Frequenz-Wandlers 4. Die Frequenz dieser Impulse ist dabei proportional dem Wert der Integrale der beiden Eingangsspannungen des Differentialintegrators 20.

Der Phasenschieber 12 besitzt vorzugsweise einen der drei in den Figuren 3 bis 5 dargestellten Aufbauten.

Der in der Fig. 3 dargestellte Phasenschieber 12 besteht aus einem mittels eines Operationsverstärkers 30 aufgebauten nicht invertierenden Verstärker, in dessen Rückkopplungszweig zwischen dem Ausgang und dem invertierenden Eingang jeweils des Operationsverstärkers 30 ein Kondensator 31 parallel zu einem Widerstand 32 geschaltet ist. Der invertierende Eingang des Operationsverstärkers 30 liegt zusätzlich noch über einen Widerstand 33 an Masse, während der nichtinvertierende Eingang und der Ausgang des Operationsverstärkers 30 jeweils den Eingang und den Ausgang des Phasenschiebers 12 bilden.

Der in der Fig. 4 dargestellte Phasenschieber 12 besteht aus einem ebenfalls mittels des Operationsverstärkers 30 aufgebauten diesmal invertierenden Verstärker, in dessen Rückkopplungszweig zwischen dem Ausgang und dem invertierenden Eingang des Operationsverstärkers 30 wieder der Kondensator 31 parallel zu dem Widerstand 32 geschaltet ist. Der nichtinvertierende Eingang des Operationsverstärkers 30 liegt diesmal an Masse, während der invertierende Eingang über den Widerstand 33 mit dem Eingang des Phasenschiebers 12 verbunden ist und der Ausgang des Operationsverstärkers 30 den Ausgang des Phasenschiebers 12 bildet.

Der in der Fig. 5 dargestellte passive Phasenschieber 12 besteht nur aus dem Kondensator 31, der parallel zum Widerstand 32 geschaltet ist. Er wird vorzugsweise zwischen dem Spannungseingang 18 des Elektrizitätszählers und dem Impulsamplituden-Modulator 14 verwendet, da der Spannungseingang 18 ein signalstarker Eingang ist, der direkt mit dem Energieversorgungsnetz 1 verbunden ist und somit keiner Verstärkung bedarf. Die in den Figuren 3 und 4 dargestellten aktiven Phasenschieber 12 werden dagegen vorzugsweise zwischen dem Integrator 11 und dem Impulsbreiten-Impulslücken-Modulator 13 verwendet, da ein durch den Integrator 11 gedämpftes Signal der Verstärkung bedarf.

Die Sekundärwicklung des Transformators 10 ist durch den Integrator 11 nur unwesentlich belastet: Der Transformator 10 arbeitet so praktisch im Leerlauf und verbraucht praktisch keinen Sekundärstrom. Der stromgespeiste und sekundärseitig annähernd leerlaufende Transformator 10 misst die Ableitung di/dt eines zugehörigen Netzstromes i, der im Leiter 2a, 2b bzw. 2c fliesst. Der durch den Elektrizitätszähler zu messende Strom i durchfliesst die Primärwicklung des Transformators 10 und induziert in dessen Sekundärwicklung eine Spannung u, die proportional di/dt ist. Diese Spannung u wird im RC-Glied des Integrators 11 integriert, so dass dessen Ausgangsspannung proportional dem zu messenden Strom i ist.

Der Integrator 11, der nur aus passiven Bauelementen besteht, ist kein idealer Integrator, d. h. es entstehen bei der Integration Restfehler im Winkel, welche durch den Phasenschieber 12 für 50 Hz (Europa) bzw. 60 Hz (USA) korrigiert werden müssen. Wegen der nichtidealen Integration werden die anderen Frequenzen dagegen in Phase und Amplitude etwas verfälscht. Die durch den Integrator 11 verursachte unerwünschte Phasenverschiebung und Dämpfung werden mittels des Kondensators 31 des Phasenschiebers 12 bzw. des Verstärkungsfaktors des rückgekoppelten Operationsverstärkers 30 wieder rückgängig gemacht bzw. kompensiert. Die Schaltung ist dabei so abzustimmen, dass sie den Eingängen des Impulsbreiten-Impulslücken-Impulsamplituden-Modulators 13;14 bei 50 Hz (Europa) bzw. bei 60 Hz (USA) ein phasen- und amplitudenrichtiges Eingangssignal liefert und die Fehler bei Frequenzabweichungen innerhalb der zugelassenen Toleranzen liegen.

Ist der Phasenschieber 12 zwischen dem Spannungseingang 18 und dem Amplitudeneingang 19 des Impulsamplituden-Modulators 14 angeordnet, dann ist er so einzustellen, dass ein durch den Elektizitätszähler zu messendes Spannungssignal $u_R$ um einen gleichen Wert phasenverschoben wird wie die Ausgangsspannung des Integrators 11 durch den letzteren phasenverschoben wird.

Mit dem Kondensator 31 des Phasenschiebers 12 kann auch ein Phasenabgleich des gesamten Elektrizitätszählers erfolgen, zum Messen z. B. von Blindenergie, bei der bekanntlich noch eine zusätzliche Phasenverschiebung von 90° vorhanden sein muss.

Das nur mit passiven Bauelementen aufgebaute RC-Glied des Integrators 11 hat die Vorteile, dass bei z. B. Phasenanschnittsteuerungen durch das di/dt Dirac-Stossspannungen entstehen, welche durch das passive RC-Glied ohne Schwierigkeiten verarbeitet werden können, ohne dabei Störungen zu verursachen, dass bei Phasenanschnittsteuerungen keine Schwierigkeiten mit Gleichstromanteilen, Oberwellen oder hochfrequenten Störsignalen entstehen, die nur stark gedämpft wirksam werden, dass der Kondensator 16 so angeordnet werden kann, dass die nachgeschaltete Schaltung 12 bzw. 13 gleichstromfest ist, dass keine "Offset"-Spannung vorhanden ist, die integriert werden könnte und dann den Integratorausgang in die Sättigung treiben könnte.

Je grösser die Zeitkonstante des Integrators 11 gewählt wird, je besser ist die durch den Integrator 11 verwirklichte Integration und desto weniger muss mittels des Kondensators 31 korrigiert werden; um so grösser muss aber wieder dagegen die Verstärkung des rückgekoppelten Operationsverstärkers 30 sein.

Da der Wert des Drahtwiderstandes der Sekundärwicklung des Transformators 10 im Wert des Widerstandes 17 bzw. in die Werte der Widerstände 17a und 17b einzubeziehen ist, ist er relativ klein zu wählen und temperaturmässig mit einem NTC-Widerstand (Negativer-Temperaturkoeffizient-Widerstand) zu kompensieren. Eine andere Möglichkeit besteht darin, die Sekundärwicklung aus Manganin herzustellen.

Der ferromagnetische Kern des Transformators 10 besitzt vorzugsweise einen Luftspalt. Er kann dann bei entsprechender Dimensionierung des Luftspaltes nicht durch Gleichstromanteile des zu messenden Stromes i in die Sättigung getrieben werden und so das Messresultat verfälschen.

Der Kern des Transformators 10 ist vorzugsweise ein mit einem Luftspalt versehener Ferrit-Topfkern. Ferrit-Topfkerne sind handelsüblich erhältlich und brauchen nicht speziell hergestellt zu werden. Anstelle des Ferrit-Topfkerns mit Luftspalt kann auch eine andere Kernkonfiguration verwendet werden, welche das durch den Strom i erzeugte Magnetfeld verstärkt, Fremdmagnetfelder fernhält sowie mit einer einfach zu bewickelnden Spule versehen werden kann. Besonders wirtschaftlich wäre damit auch die Verwendung eines E-Kerns aus Trafoblech, wobei der Luftspalt z. B. als Keramikelement ausgebildet ist und als Anschlag bei der Verschachtelung der Trafobleche verwendet werden kann.

Der Transformator 10 kann aber auch ein sogenannter aktiver Stromwandler sein, wie z. B. der in der EP 0 335 511 A1 (entspricht der britischen Patentanmeldung Nr. 8 805 245 und der US-Patentanmeldung Nr. 318 796) beschriebene. In diesem Fall besitzt der Transformator 10 dann noch eine dritte Wicklung als Rückkopplungswicklung, die mit einem Eingang eines Verstärkers verbunden ist, der seinerseits die Sekundärwicklung des Transformators 10 speist. Der ferromagnetische Kern des Transformators 10 besteht dann aus zwei Magnetkreisen, die einen gemeinsamen Magnetpfad aufweisen, der mindestens von der dritten Wicklung umgeben ist. Die Sekundärwicklung umgibt entweder ebenfalls diesen gemeinsamen Magnetpfad oder sie umgibt den nicht gemeinsamen Magnetpfad einer der beiden Magnetkreise, während der andere Magnetkreis von der Primärwicklung umgeben ist. Die Primärwicklung besitzt dabei vorzugsweise nur eine halbe Windung und die Gestalt einer Haarnadelkurve. Der Verstärker arbeitet als Regelverstärker und regelt den Gesamtmagnetfluss im gemeinsamen Magnetpfad der beiden Magnetkreise auf Null. Der Kern des Transformators 10 besteht in diesem Fall vorzugsweise aus einem Ferritgehäuse und einem einstellbaren Ferritkern zur Einstellung des Luftspaltes. Der letztere ist mit Luft oder mindestens teilweise mit einem nichtferromagnetischen Material gefüllt, wie z. B. mit Alumina.

Der Impulsbreiten-Impulslücken-Modulator 13 wandelt das Ausgangssignal des Integrators 11 bzw. des Phasenschiebers 12, welches, wie bereits erwähnt, proportional dem zu messenden Strom i ist, um in Impulse, deren Tastverhältnis proportional dem Strom i ist. Diese Impulse werden im Impulsamplituden-Modulator 14 amplitudenmoduliert, so dass im Betrieb an dessen Ausgang Impulse und Impulslücken erscheinen, deren algebraische Summenflächen proportional dem Produkt $u_R \cdot i$, also proportional der gemessenen Leistung ist. Der Impulsbreiten-Impulslücken-Impulsamplituden-Modulator 13;14 arbeitet somit als Multiplizierer. Um den Wert dieser Leistung zu erhalten, werden die Flächen der Impulse und der Impulslücken in den RC-Gliedern 26;28 und 27;29 des nachgeschalteten Differentialintegrators 20 integriert, der gleichzeitig die Differenz der beiden Flächen und damit die algebraische Summenfläche bildet, die, da die Integration zeitlich fortlaufend erfolgt, die gemessene Energie ergibt. Die Schaltung 21;22;23;24 wandelt anschliessend den so gefundenen Wert der gemessenen Energie um in Impulse, deren Frequenz proportional diesem Wert der Energie ist.

Da die Spannung $u_R$ des Energieversorgungsnetzes 1 direkt durch Widerstand 15a auf den Impulsamplituden-Modulator 14 bzw. auf den Phasenschieber 12 geführt ist, wird eine gute Stromeinprägung auf den Integrator erreicht.

Bei einem Dreiphasen-Elektrizitätszähler erfolgt die Summation der Energie der drei Phasen in der in der Fig. 1 dargestellten ersten Variante am Eingang des Strom/Frequenz-Wandlers 4 durch Summation der drei Ausgangssströme der Eingangsschaltungen 3a, 3b und 3c.

In der Fig. 1 bilden die Bauelemente 15a, 15b, 15c und ggf. 12 eine Spannungsaufbereitungsschaltung 34 und die Bauelemente 10, 11, ggf. 12 und 13 eine Stromaufbereitungsschaltung 35.

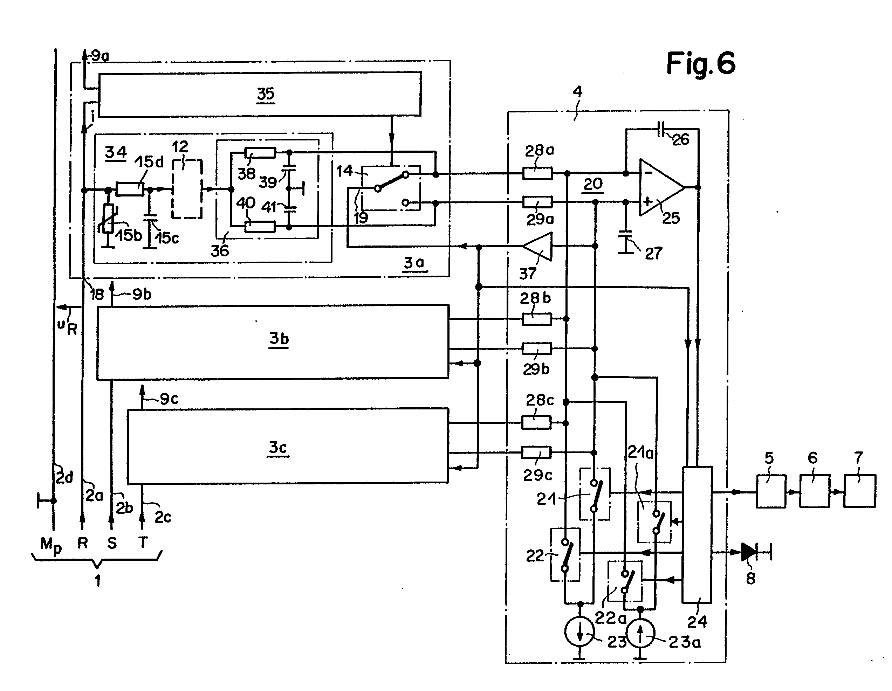

In der Fig. 6 ist als zweite Variante der erfindungsgemässen Anordnung wieder ein Dreiphasen-Elektrizitätszähler dargestellt, der ähnlich aufgebaut ist wie derjenige der ersten Variante mit dem Unterschied, dass die Spannungsaufbereitungsschaltung 34 einen andern Inhalt aufweist und der Strom/Frequenz-Wandler 4 etwas abgeändert ist. Der Differentialintegrator 20 weist nämlich anstelle eines einzigen Widerstandspaares 28;29 an seinem Eingang ein Widerstandspaar 28a;29a bzw. 28b;29b bzw. 28c;29c pro Phase auf. Dabei sind erste Pole der Widerstände 28a, 29a, 28b, 29b, 28c und 29c eines jeden Widerstandspaares 28a;29a bzw. 28b;29b bzw. 28c;29c mit den beiden Ausgängen des der betreffenden Phase zugehörigen Impulsamplituden-Modulators 14 verbunden, während jeweils ein zweiter Pol eines ersten Widerstandes 28a bzw. 28b bzw. 28c eines jeden Widerstandspaares 28a;29a bzw. 28b;29b bzw. 28c;29c mit einem invertierenden Eingang und ein zweiter Pol eines zweiten Widerstandes 29a bzw. 29b bzw. 29c eines jeden Widerstandspaares 28a;29a bzw. 28b;29b bzw. 28c;29c mit einem nichtinvertierenden Eingang jeweils des Operationsverstärkers 25 des Differentialintegrators 20 verbunden ist. Der pro Phase vorhandene Spannungseingang 18 des Elektrizitätszählers ist jeweils über ein RC-Netzwerk 36 mit den beiden Ausgängen des Impulsamplituden-Modulators 14 verbunden. Der nichtinvertierende Eingang des Operationsverstärkers 25 ist über einen Verstärker 37, der einen Verstärkungsfaktor Eins aufweist und dessen Ausgang der zweite Ausgang des Differentialintegrators 20 ist, mit einem Eingang aller Impulsamplituden-Modulatoren 14 sowie mit dem ersten Eingang der Logikschaltung 24 verbunden, der somit nicht unmittelbar, wie in der Darstellung der Fig. 1, mit dem nichtinvertierenden Eingang des Operationsverstärkers 25 verbunden ist. Der Ausgang des Operationsverstärkers 25 ist auf den zweiten Eingang der Logikschaltung 24 geführt.

Die Spannungsaufbereitungsschaltung 34 der zweiten Variante (siehe Fig. 6) besteht aus dem spannungsabhängigen VDR-Widerstand 15b, dem Widerstand 15d, dem Kondensator 15c, ggf. dem Phasenschieber 12 und dem RC-Netzwerk 36, welches seinerseits aus zwei Widerständen 38 und 40 und zwei Kondensatoren 39 und 41 besteht.

Die beiden Ausgänge des Impulsamplituden-Modulators 14 bilden wieder die zwei in Gegentakt betriebenen Ausgänge des Impulsbreiten-Impulslücken-Impulsamplituden-Modulators 13;14 und damit der zugehörigen Eingangsschaltung 3a, 3b bzw. 3c. Diese beiden Ausgänge sind diesmal jedoch pro Eingangsschaltung 3a, 3b und 3c getrennt auf je einen von zwei Eingängen des Differentialintegrators 20 geführt, der diesmal zwei solcher Eingänge pro Eingangsschaltung 3a, 3b und 3c, also total sechs Eingänge aufweist. Der Kondensator 15c, der spannungsabhängige VDR-Widerstand 15b, der Widerstand 15d und, falls vorhanden, der Phasenschieber 12 sind genau so angeschlossen wie in der ersten Variante.

Der pro Phase vorhandene Spannungseingang 18 des Elektrizitätszählers ist ggf. über den Phasenschieber 12 auf den Eingang des zugehörigen RC-Netzwerkes 36 geführt, der von den miteinander verbundenen ersten Polen der Widerstände 38 und 40 gebildet ist, während erste Pole der beiden Kondensatoren 39 und 41 an Masse liegen. Die zweiten Pole des Widerstandes 38 und des Kondensators 39 sind miteinander verbunden und bilden einen ersten der beiden Ausgänge des RC-Netzwerkes 36, der Aufbereitungsschaltung 34 und damit der zugehörigen Eingangsschaltung 3a, 3b bzw. 3c, da dieser Ausgang mit einem der beiden Ausgänge des zugehörigen Impulsamplituden-Modulators 14 verbunden ist. Die zweiten Pole des Widerstandes 40 und des Kondensators 41 sind ebenfalls miteinander verbunden und bilden einen zweiten der beiden Ausgänge des RC-Netzwerkes 36, der Aufbereitungsschaltung 34 und damit der zugehörigen Eingangsschaltung 3a, 3b bzw. 3c, da auch dieser Ausgang mit einem der beiden Ausgänge des zugehörigen Impulsamplituden-Modulators 14 verbunden ist.

Die ersten Ausgänge der drei Eingangsschaltungen 3a, 3b und 3c sind nicht wie in der ersten Variante unmittelbar sondern über die Widerstände 28a, 28b und 28c miteinander verbunden, während die zweiten Ausgänge der drei Eingangsschaltungen 3a, 3b und 3c ihrerseits nicht unmittelbar, sondern über die Widerstände 29a, 29b und 29c miteinander verbunden sind.

Jede Eingangsschaltung 3a, 3b und 3c besitzt einen Amplitudeneingang, der innerhalb der zugehörirgen Eingangsschaltung 3a, 3b bzw. 3c mit dem Amplitudeneingang 19 des zugehörigen Impulsamplituden-Modulators 14 verbunden ist. Der diesmal einpolige Umschalter des Impulsamplituden-Modulators 14 schaltet wieder im Rhythmus seiner Steuerimpulse den Amplitudeneingang 19 des Impulsamplituden-Modulators 14 abwechselnd auf einen der beiden Ausgänge des zugehörigen Impulsbreiten-Impulslücken-Impulsamplituden-Modulators 13;14. Die Amplitudeneingänge der drei Eingangsschaltungen 3a, 3b und 3c sind miteinander verbunden.

Die Bauelemente 38 und 39 bzw. 40 und 41 stellen je ein Tiefpassfilter dar, welches Störsignale eliminiert, die möglicherweise am Spannungseingang 18 des Elektrizitätszählers vorhanden sind. Die Widerstandswerte der Widerstände 38 und 40 sind um eine Grössenordnung höher zu wählen als diejenigen der Widerstände 28a, 28b, 28c, 29a, 29b und 29c, welche z. B. je einen Widerstandswert von 100 kOhm aufweisen. In diesem Fall beträgt der Wert der Widerstände 38 und 40 vorzugsweise je 1 MOhm und diese Widerstände stellen dann zusammen mit der Spannung $u_R$ des Energieversorgungsnetzes 1 je eine Stromquelle dar, die den nachgeschalteten Differentialintegrator 20 mit je einem Eingangsstrom speisen, der dessen Kondensator 26 bzw. 27 lädt und von diesem integriert wird.

Da die beiden Eingänge des Operationsverstärkers 25 annähernd eine gleiche Spannung aufweisen, besitzen diese beiden Eingänge und, wegen der Anwesenheit des Verstärkers 37, der Amplitudeneingang 19 des Impulsamplituden-Modulators 14 eine gleiche Spannung. Dies führt dazu, dass in jeder der beiden Stellungen des Umschalters des Impulsamplituden-Modulators 14 über jeweils eine der beiden Widerstandsgruppen 28a;28b;28c bzw. 29a;29b;29c kein Spannungsabfall vorhanden ist und demnach in derselben idealerweise kein Strom fliessen kann. In jeder der beiden Stellungen des Umschalters speist somit eine der beiden Stromquellen $u_R$;38 bzw. $u_R$;40 einen der beiden Kondensatoren 26 bzw. 27, während der andere Kondensator 27 bzw. 26 durch keinen Strom erreicht wird. Dabei vertauschen die beiden Stromquellen $u_R$;38 und $u_R$;40 und die beiden Kondensatoren 26 und 27 bei jedem Stellungswechsel des Umschalters ihre Rollen.

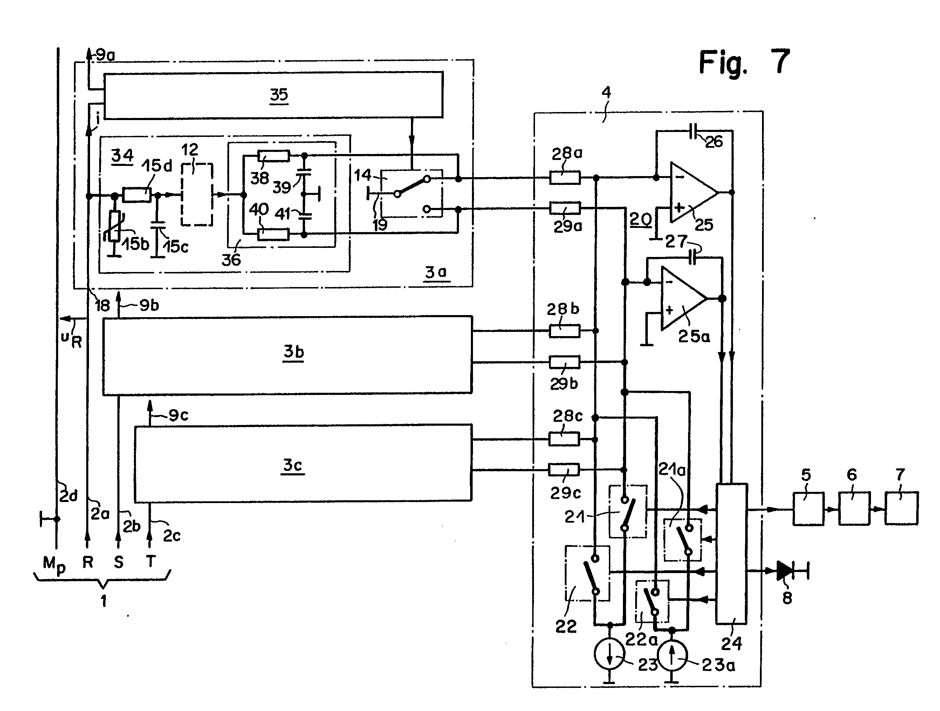

Die in der Fig. 7 dargestellte dritte Variante der erfindungsgemässen Anordnung ist ähnlich aufgebaut wie die in der Fig. 6 dargestellte zweite Variante mit folgenden Unterschieden:
- Der Verstärker 37 mit seinen Anschlüssen ist nicht mehr vorhanden.
- Der Amplitudeneingang 19 aller Impulsamplituden-Modulatoren 14 liegt an Masse.
- Der nichtinvertierende Eingang des Operationsverstärkers 25 liegt ohne zwischengeschalteten Kondensator 27 an Masse, wobei der Operationsverstärker 25 und der Kondensator 26 ein Teil eines ersten Miller-Integrators 28a;28b;28c;25;26 sind.
- Der zweite Pol der Widerstände 29a, 29b und 29c ist nicht mehr mit dem nichtinvertierenden Eingang des Operationsverstärkers 25, sondern mit einem invertierenden Eingang eines weiteren Operationsverstärkers 25a verbunden, zwischen dessen Ausgang und invertierendem Eingang diesmal der Kondensator 27 angeordnet ist. Der Ausgang des Operationsverstärkers 25a ist unmittelbar auf den ersten Eingang der Logikschaltung 24 geführt, während der nichtinvertierende Eingang des Operationsverstärkers 25a an Masse liegt. Der Operationsverstärker 25a und der Kondensator 27 sind ein Teil eines zweiten Miller-Integrators 29a;29b;29c;25a;27.

Die Ausgänge der beiden Operationsverstärker 25 und 25a bilden die Ausgänge der beiden Miller-Integratoren 28a;28b;28c;25;26 und 29a;29b;29c;25a;27 und damit die beiden Ausgänge der Anordnung zum Integrieren der Flächen von Impulsen und Impulslücken. Der Differentialintegrator 20, in dem in der ersten Variante mittels der RC-Glieder 26;28 und 27;29 und in der zweiten Variante mittels der RC-Glieder 26;28a;28b;28c und 27;29a;29b;29c die Flächen der Impulse und der Impulslücken, die im Betrieb am Ausgang der Impulsamplituden-Modulatoren 14 jeweils vorhanden sind, integriert werden, ist in der dritten Variante durch die beiden Miller-Integratoren 28a;28b;28c;25;26 und 29a;29b;29c;25a;27 ersetzt worden, die beide zusammen ebenfalls, genau wie der Differentialintegrator 20, eine im Strom/Frequenz-Wandler 4 enthaltene Anordnung zum Integrieren der Flächen dieser Impulse und Impulslücken bilden. Dabei werden die Flächen der Impulse durch den einen und die Flächen der Impulslücken durch den andern der beiden Miller-Integratoren 28a;28b;28c;25;26 und 29a;29b;29c;25a;27 integriert.

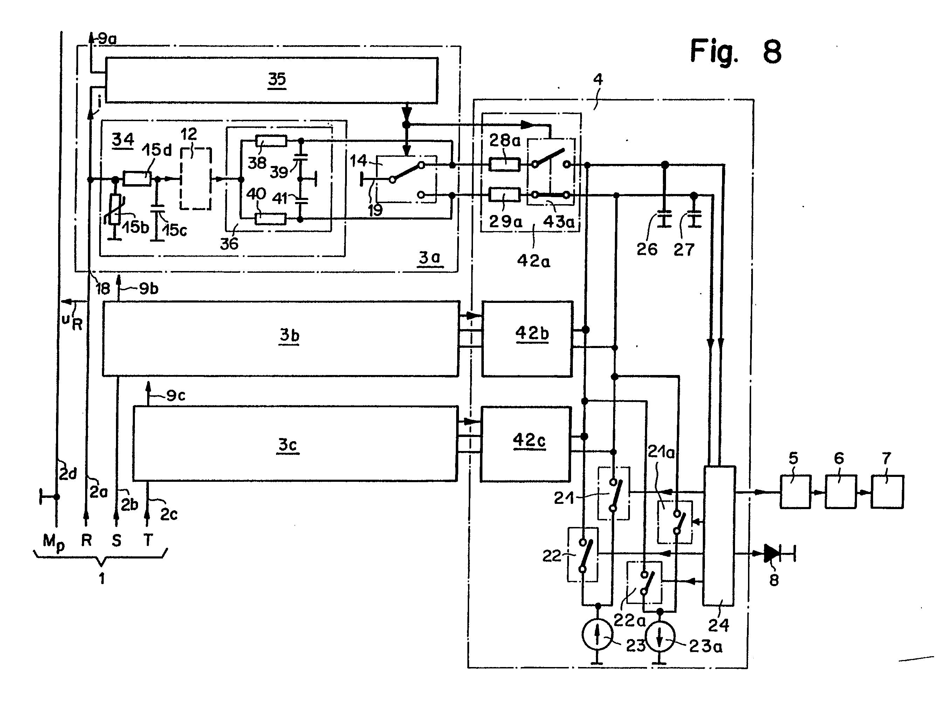

Die in der Fig. 8 dargestellte vierte Variante der erfindungsgemässen Anordnung ist ähnlich aufgebaut wie die in der Fig. 7 dargestellte dritte Variante mit folgenden Unterschieden:

- Die Operationsverstärker 25 und 25a sind nicht mehr vorhanden.
- Die beiden ersten Pole der beiden Kondensatoren 26 und 27 liegen an Masse und die beiden zweiten Pole der Kondensatoren 26 und 27 bilden die beiden Ausgänge der Anordnung zum Integrieren der Flächen von Impulsen und Impulslücken. Der zweite Pol des Kondensators 26 ist mit dem zweiten Eingang der Logikschaltung 24 und der zweite Pol des Kondensators 27 mit dem ersten Eingang der Logikschaltung 24 verbunden.
- Der zweite Pol des Widerstandes 28a ist über einen ersten Schaltkontakt eines zugehörigen zweipoligen Schalters 43a mit dem zweiten Pol des Kondensators 26 verbunden, während der zweite Pol des Widerstandes 29a über einen zweiten Schaltkontakt des zugehörigen zweipoligen Schalters 43a auf den zweiten Pol des Kondensators 27 geführt ist, wobei der zweipolige Schalter 43a mit seinen zwei Schaltkontakten und die zugehörigen Widerstände 28a und 29a ein zur Eingangsschaltung 3a gehörendes Eingangsbauteil 42a des Strom/Frequenz-Wandlers 4 bilden.
- Zu den Eingangsschaltungen 3b und 3c gehört ebenfalls je ein Eingangsbauteil 42b bzw. 42c des Strom/Frequenz-Wandlers 4, wobei der nicht dargestellte Aufbau der Eingangsbauteile 42b und 42c gleich ist demjenigen des Eingangsbauteils 42a, in dem anstelle des zweipoligen Schalters 43a ein nicht dargestellter zweipoliger Schalter 43b bzw. 43c und anstelle der Widerstände 28a und 29a die Widerstände 28b und 29b bzw. 28c und 29c vorhanden sind, und wobei die zweipoligen Ausgänge der Eingangsbauteile 42b und 42c dem zweipoligen Ausgang des Eingangsbauteils 42c parallel geschaltet sind.
- Der Steuereingang des Impulsamplituden-Modulators 14 der Eingangsschaltung 3a ist mit dem Steuereingang des zweipoligen Schalters 43a, derjenige der Eingangsschaltung 3b mit demjenigen des zweipoligen Schalters 43b und derjenige der Eingangsschaltung 3c mit demjenigen des zweipoligen Schalters 43c verbunden.

Da die zweipoligen Schalter 43a, 43b und 43c gleichzeitig umgeschaltet werden wie der Umschalter des zugehörigen Impulsamplituden-Modulators 14, kann natürlich der Schalter 43a, 43b oder 43c jeweils auch mit dem Umschalter des zugehörigen Impulsamplituden-Modulators 14 zusammengelegt werden zu einem einzigen, dann mindestens dreipoligen Schalter. Es sind dabei zusätzlich zum Umschalter des Impulsamplituden-Modulators 14 immer mindestens zwei Schaltkontakte pro Phase vorhanden.

Die in der Fig. 8 dargestellte vierte Variante arbeitet ähnlich wie die in der Fig. 7 dargestellte dritte Variante mit dem Unterschied, dass die beiden Miller-Integratoren 28a;28b;28c;25;26 und 29a;29b;29c;25a;27 je durch einen RC-Integrator 28a;28b;28c;26 bzw. 29a;29b;29c;27 ersetzt sind.

Die zweipoligen Schalter 43a, 43b und 43c verhindern das Entladen der Kondensatoren 26 und 27 über den zugehörigen Widerstand 28a, 29a, 28b, 29b, 28c bzw. 29c, wenn die ersten Pole dieser Widerstände durch den Umschalter des zugehörigen Pulsamplituden-Modulators an Masse gelegt werden. Zu diesem Zweck ist einer der beiden Schaltkontakte der zweipoligen Schalter 43a, 43b und 43c ein Arbeitskontakt ("normally open contact") und der andere ein Ruhekontakt ("normally closed contact"). In der Darstellung der Fig. 8 ist der erste Schaltkontakt des zweipoligen Schalters 43a ein Arbeitskontakt, da der zum Widerstand 28a gehörende Kontakt des Umschalters des zugehörigen Impulsamplituden-Modulators 14 ein Ruhekontakt ist. Der zweite Schaltkontakt des zweipoligen Schalters 43a ist dann ein Ruhekontakt, weil der zum Widerstand 29a gehörende Kontakt des Umschalters des zugehörigen Impulsamplituden-Modulators 14 ein Arbeitskontakt ist.

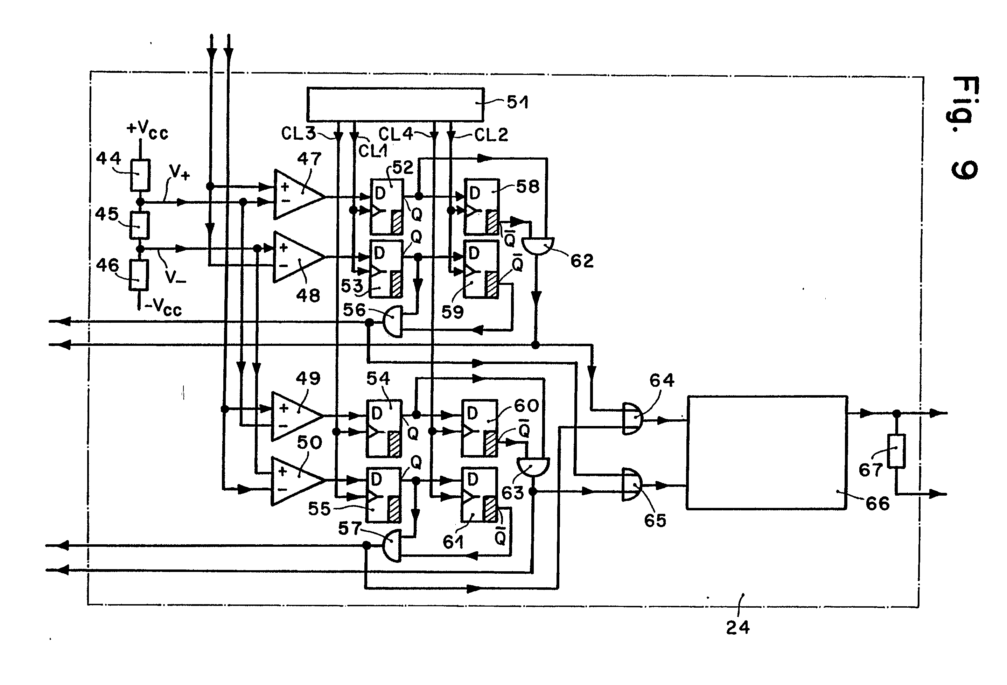

Die Logikschaltung besitzt z.B. den in der Fig. 9 dargestellten Aufbau und besteht dann mindestens aus drei Widerständen 44 bis 46, vier Komparatoren 47 bis 50, acht Flip Flops 52 bis 55 und 58 bis 61, einem Taktgenerator 51, vier Und-Gattern 56, 57, 62 und 63, zwei Oder-Gattern 64 und 65, einem Vorwärts/Rückwärts-Zähler 66 und einem weiteren Widerstand 67. Die Flip Flops sind dabei vorzugsweise D-Flip Flops.

Die drei Widerstände 44, 45 und 46 sind in der angegebenen Reihenfolge in Reihe geschaltet. Ein erster Pol der Reihen schaltung 44;45;46, die einen Spannungsteiler darstellt, wird von einer positiven und ein zweiter Pol von einer negativen Speisegleichspannung $V_{CC}$ bzw. $-V_{CC}$ gespeist. Der gemeinsame Pol der Widerstände 44 und 45, an dem eine Gleichspannung V+ ansteht, ist mit den invertierenden Eingängen der beiden Komparatoren 47 und 49 verbunden, und der gemeinsame Pol der Widerstände 45 und 46, an dem eine Gleichspannung V- ansteht, ist mit den nichtinvertierenden Eingängen der Komparatoren 48 und 50 verbunden. Innerhalb der Logikschaltung 24 ist deren erster Eingang auf den nichtinvertierenden Eingang des Komparators 47 und auf den invertierenden Eingang des Komparators 48 geführt, während der zweite Eingang der Logikschaltung 24 auf den nichtinvertierenden Eigang des Komparators 49 und den invertierenden Eingang des Komparators 50 geführt ist. Die Ausgänge der vier Komparatoren 47 bis 50 sind je auf einen D-Eingang eines der vier Flip Flops 52, 53, 54 bzw. 55 geführt, deren Q-Ausgänge ihrerseits je auf einen D-Eingang eines der vier Flip Flops 58, 59, 60 bzw. 61 geführt sind.

Der Taktgenerator 51 besteht vorzugsweise aus einem bekannten Quarz-Oszillator, dem ein bekannter Frequenzteiler nachgeschaltet ist, und erzeugt vier rechteckförmige Taktsignale CL1, CL2, CL3 und CL4. Das Taktsignal CL1 speist die Takteingänge der Flip Flops 52 und 53, das Taktsignal CL2 die Takteingänge der Flip Flops 58 und 59, das Taktsignal CL3 die Takteingänge der Flip Flops 54 und 55 und das Taktsignal CL4 die Takteingänge der Flip Flops 60 und 61. Der Q-Ausgang des Flip Flops 53 und der invertierte Q-Ausgang des Flip Flops 59 sind je mit einem von zwei Eingängen des Und-Gatters 56 verbunden, dessen Ausgang einerseits auf einen ersten Steuerausgang der Logikschaltung 24 und anderseits auf einen ersten Eingang des Oder-Gatters 65 geführt ist. Der Q-Ausgang des Flip Flops 52 und der invertierte Q-Ausgang des Flip Flops 58 sind je mit einem von zwei Eingängen des Und-Gatters 62 verbunden, dessen Ausgang einerseits auf einen zweiten Steuerausgang der Logikschaltung 24 und anderseits auf einen ersten Eingang des Oder-Gatters 64 geführt ist. Der Q-Ausgang des Flip Flops 55 und der invertierte Q-Ausgang des Flip Flops 61 sind je mit einem von zwei Eingängen des Und-Gatters 57 verbunden, dessen Ausgang einerseits auf einen dritten Steuerausgang der Logikschaltung 24 und anderseits auf einen zweiten Eingang des Oder-Gatters 64 geführt ist. Der Q-Ausgang des Flip Flops 54 und der invertierte Q-Ausgang des Flip Flops 60 sind je mit einem von zwei Eingängen des Und-Gatters 63 verbunden, dessen Ausgang einerseits auf einen vierten Steuerausgang der Logikschaltung 24 und anderseits auf einen zweiten Eingang des Oder-Gatters 65 geführt ist. Der Ausgang des Oder-Gatters 64 ist mit einem Vorwärts-Zähleingang und der Ausgang des Oder-Gatters 65 mit einem Rückwärts-Zähleingang des Vorwärts/Rückwärts-Zählers 66 verbunden, dessen Ausgang unmittelbar auf einen ersten Signalausgang und über den Widerstand 67 auf einen zweiten Signalausgang der Logikschaltung 24 geführt ist.

In der Logikschaltung 24 gehören somit zu dessem ersten Eingang die beiden Komparatoren 47 und 48 und zu dessem zweiten Eingang die Komparatoren 49 und 50. Zum Komparator 47 gehören die Flip Flops 52 und 58 sowie das Und-Gatter 62, zum Komparator 48 die Flip Flops 53 und 59 sowie das Und-Gatter 56, zum Komparator 49 die Flip Flops 54 und 60 sowie das Und-Gatter 63 und zum Komparator 50 die Flip Flops 55 und 61 sowie das Und-Gatter 57. Das Taktsignal CL1 gehört zu den Flip Flops 52 und 53, das Taktsignal CL2 zu den Flip Flops 58 und 59, das Taktsignal CL3 zu den Flip Flops 54 und 55 und das Taktsignal CL4 zu den Flip Flops 60 und 61.

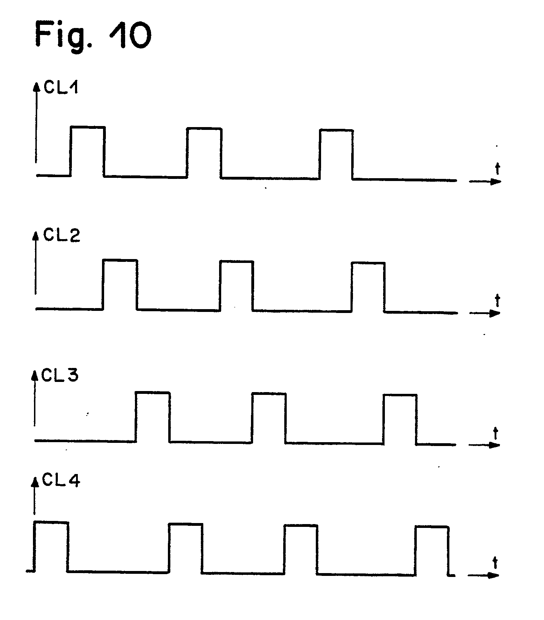

Die Fig. 10 stellt den zeitlichen Verlauf der vier Taktsignale CL1 bis CL4 dar, die alle aus rechteckförmigen Impulsen bestehen. Die Impulse des Taktsignals CL2 beginnen jeweils, wenn diejenigen des Taktsignals CL1 enden, die Impulse des Taktsignals CL3 beginnen jeweils, wenn diejenigen des Taktsignals CL2 enden, die Impulse des Taktsignals CL4 beginnen jeweils, wenn diejenigen des Taktsignals CL3 enden und die Impulse des Taktsignals CL1 beginnen jeweils, wenn diejenigen des Taktsignals CL4 enden.

Die beiden Komparatoren 47 und 48 überwachen den Pegel am ersten und die beiden Komparatoren 49 und 50 den Pegel am zweiten Eingang der Logikschaltung 24 und damit je einen der Pegel an einem der beiden Ausgänge der Anordnung zum Integrieren der Flächen der Impulse und Impulslücken. Die vier Komparatoren 47 bis 50 vergleichen den von ihnen jeweils überwachten Pegel mit einem Spannungsfenster V+;V-, welches durch die beiden Gleichspannungen V+ und V- gebildet ist. Liegen die gemessenen und an den beiden Eingängen der Logikschaltung 24 anstehenden Integralwerte spannungsmässig innerhalb des Spannungsfensters V+;V-, dann geschieht nichts. Liegen diese Integralwerte dagegen spannungsmässig ausserhalb des Spannungsfensters V+;V-, dann ändert das Ausgangssignal des zugehörigen Komparators 47, 48, 49 bzw. 50 seinen Logikwert, der bei der nächsten steigenden Flanke des zugehörigen Taktsignals CL1 bzw. CL3 in das zugehörige Flip Flop 52, 53, 54 bzw. 55 geladen wird, um anschliessend zeitverzögert bei der steigenden Flanke des zugehörigen Taktsignals CL2 bzw. CL4 in das zugehörige Flip Flop 58, 59, 60 bzw. 61 übernommen zu werden. Ein jedes der vier Flip Flops 58 bis 61 enthält somit zeitverzögert die gleiche Information wie das zugehörige Flip Flop 52, 53, 54 bzw. 55. Aendert eines der Flip Flops 52, 53, 54 bzw. 55 seinen Inhalt von einem Logikwert "0" auf einen Logikwert "1", d. h. erscheint an seinem Q-Ausgang ein Logikwert "1", wenn am invertierten Q-Ausgang des zugehörigen Flip Flops 58, 59, 60 bzw. 61 ein Logikwert "1" ansteht, dann erscheint am Ausgang des zugehörigen Und-Gatters 62, 56, 63 bzw. 57 ein Logiwert "1", der einerseits über einen zugehörigen Steuerausgang der Logikschaltung 24 dem Steuereingang eines der Schalter 21, 21a, 22 oder 22a zugeführt wird und diesen umschaltet, wodurch der zugehörige der beiden Kondensatoren 26 oder 27 entladen wird (siehe Fig. 1, Fig. 6, Fig. 7 und Fig. 8), und der anderseits über eines der beiden Oder-Gatter 64 oder 65 dem Vorwärts- bzw. dem Rückwärts-Zähleingang des Vorwärts/Rückwärts-Zählers 66 zugeführt wird, je nachdem, ob die integrierten Flächen positive oder negative Integralwerte besitzen. Durch das Entladen des Kondensators 26 bzw. .27 verkleinert sich sowohl der Absolutwert des zugehörigen Integralwertes als auch der Absolutwert des Pegels am zugehörigen Eingang der Logikschaltung 24 und schaltet, sobald der letztere die Gleichspannung V+ bzw. V- erreicht, den zugehörigen Komparator 47, 48, 49 bzw. 50 und die zugehörigen Flip Flops 52, 53, 54 bzw. 55 wieder in ihre ursprünglichen Lage zurück. Dadurch nehmen die Logikwerte am Ausgang des zugehörigen Und-Gatters 62, 56, 63 bzw. 57 und des zugehörigen Oder-Gatters 64 bzw. 65 wieder einen Logikwert "0" an. Mit andern Worten, die Ausgangssignale dieser Gatter sind jeweils Impulse. Die Impulse, die einem positiven Wert der Integralwerte entsprechen, werden im Vorwärts/Rückwärts-Zähler 66 vorwärts gezählt und diejenigen, die einem negativen Integralwert entsprechen, rückwärts gezählt, so dass die Anzahl Impulse am Ausgang des Vorwärts/Rückwärts-Zählers 66 der algebraischen Summe desjenigen Teils der Integralwerte entspricht, der durch das Entladen der Kondensatoren 26 und 27 vom Absolutwert der gemessenen Integralwerte abgezogen wird. Jeder Impuls am Ausgang des Vorwärts/Rückwärts-Zählers 66 entspricht einem konstanten Quantum der gemessenen Integralwerte und damit der gemessenen Leistung bzw. Energie. Der Wert der letzteren ist somit gleich der Summe des Wertes der gezählten Anzahl Impulse und der Werte, der in den Kondensatoren 26 und 27 noch gespeicherten Teile der gemessenen Integralwerte. Die letzten Werte stellen somit Messfehler dar, wenn der Zählwert der Impulse als Messwert genommen wird.

Die erfindungsgemässe Elektrizitätszähler sind geeignet grössere Signale zu messen, z. B Ströme in der Grössenordnung von 50 A.

## Ansprüche

1. Anordnung zum Messen einer elektrischen Leistung oder Energie mit einer einen Strom/Frequenz-Wandler (4) enthaltenden Aufbereitungs- und Anzeigeeinrichtung (4;5;6;7;8) am Ausgang sowie einem stromgespeisten Transformator (10) pro Phase und einem Spannungseingang (18) pro Phase, die beide mit einem zugehörigen, nachgeschalteten und pro Phase vorhandenen Impulsbreiten-Impulslücken-Impulsamplituden-Modulator (13;14) verbunden sind, der jeweils aus einem Impulsbreiten-Impulslücken-Modulator (13) und einem diesen nachgeschalteten Impulsamplituden-Modulator (14) besteht, dadurch gekennzeichnet, dass jeder Transformator (10) über einen einen hochohmigen Eingang aufweisenden Integrator (11) mit dem zugehörigen Impulsbreiten-Impulslücken-Impulsamplituden-Modulator (13;14) verbunden ist, dass jeder Impulsamplituden-Modulator (14) zwei in Gegentakt betriebene Ausgänge aufweist, die je auf einen Eingang einer im Strom/Frequenz-Wandler (4) enthaltenen Anordnung zum Integrieren der Flächen von Impulsen und Impulslücken geführt sind, welche letztere im Betrieb am Ausgang des Impulsamplituden-Modulators (14) vorhanden sind.

2. Anordnung nach Anspruch 1, dadurch gekennzeichnet, dass zwischen dem Integrator (11) und dem Impulsbreiten-Impulslücken-Impulsamplituden-Modulator (13;14) ein Phasenschieber (12) vorhanden ist.

3. Anordnung nach Anspruch 1, dadurch gekennzeichnet, dass dem Spannungseingang (18) der Anordnung ein Phasenschieber (12) nachgeschaltet ist.

4. Anordnung nach Anspruch 2 oder 3, dadurch gekennzeichnet, dass der Phasenschieber (12) aus einem mittels eines Operationsverstärkers (30) aufgebauten nichtinvertierenden Verstärker besteht, in dessen Rückkopplungszweig zwischen dem Ausgang und dem invertierenden Eingang des Operationsverstärkers (30) ein Kondensator (31) parallel zu einem Widerstand (32) geschaltet ist.

5. Anordnung nach Anspruch 2 oder 3, dadurch gekennzeichnet, dass der Phasenschieber (12) aus einem mittels eines Operationsverstärkers (30) aufgebauten invertierenden Verstärker besteht, in dessen Rückkopplungszweig zwischen dem Ausgang und dem invertierenden Eingang des Operationsverstärkers (30) ein Kondensator (31) parallel zu einem Widerstand (32) geschaltet ist.

6. Anordnung nach Anspruch 2 oder 3, dadurch gekennzeichnet, dass der Phasenschieber (12) aus einem Kondensator (31) besteht, der parallel zu einem Widerstand (32) geschaltet ist.

7. Anordnung nach einem der Ansprüche 1 bis 6, dadurch gekennzeichnet, dass der Integrator (11) aus einem RC-Tiefpassfilter besteht, welches einen Kondensator (16) und mindestens einen Widerstand (17) enthält.

8. Anordnung nach Anspruch 7, dadurch gekennzeichnet, dass das RC-Tiefpassfilter zwei Widerstände (17a, 17b) enthält, die in Reihe zu je einem von zwei Ausgangspolen des Transformators (10) angeordnet sind.

9. Anordnung nach einem der Ansprüche 1 bis 8, dadurch gekennzeichnet, dass der Transformator (10) einen Kern mit Luftspalt aufweist.

10. Anordnung nach einem der Ansprüche 1 bis 9, dadurch gekennzeichnet, dass die Anordnung zum Integrieren der Flächen der Impulse und Impulslücken ein Differentialintegrator (20) ist, dessen beide Eingänge innerhalb desselben jeweils über einen Widerstand (28 bzw. 29) mit einem invertierenden bzw. einem nichtinvertierenden Eingang eines Operationsverstärkers (25) verbunden sind, dessen Ausgang einen ersten Ausgang und dessen nichtinvertierender Eingang einen zweiten Ausgang des Differentialintegrators (20) bildet, wobei ein Kondensator (26) zwischen dem Ausgang und dem invertierenden Eingang des Operationsverstärkers (25) angeordnet ist, während ein weiterer Kodensator (27) zwischen dem nichtinvertierenden Eingang des Operationsverstärkers (25) und der Masse liegt.

11. Anordnung nach einem der Ansprüche 1 bis 9, dadurch gekennzeichnet, dass die Anordnung zum Integrieren der Flächen der Impulse und Impulslücken ein Differentialintegrator (20) ist, der an seinem Eingang ein Widerstandspaar (28a;29a bzw. 28b;29b bzw. 28c;29c) pro Phase aufweist, wobei erste Pole der Widerstände (28a, 29a, 28b, 29b, 28c und 29c) eines jeden Widerstandspaares (28a;29a bzw. 28b;29b bzw. 28c;29c) mit den beiden Ausgängen des der betreffenden Phase zugehörigen Impulsamplituden-Modulators (14) verbunden sind, während jeweils ein zweiter Pol eines ersten Widerstandes (28a bzw. 28b bzw. 28c) eines jeden Widerstandspaares (28a;29a bzw. 28b;29b bzw. 28c;29c) mit einem invertierenden Eingang und ein zweiter Pol eines zweiten Widerstandes (29a bzw. 29b bzw. 29c) eines jeden Widerstandspaares (28a;29a bzw. 28b;29b bzw. 28c;29c) mit einem nichtinvertierenden Eingang jeweils eines Operationsverstärkers (25) des Differentialintegrators (20) verbunden ist, und wobei der Ausgang des Operationsverstärkers (25) einen ersten Ausgang des Differentialintegrators (20) bildet, ein Kondensator (26) zwischen dem Ausgang und dem invertierenden Eingang des Operationsverstärkers (25) angeordnet ist und ein weiterer Kodensator (27) zwischen dem nichtinvertierenden Eingang des Operationsverstärkers (25) und der Masse liegt, und dass der nichtinvertierende Eingang des Operationsverstärkers (25) über einen Verstärker (37), der einen Verstärkungsfaktor Eins aufweist, mit einem Eingang des Impulsamplituden-Modulators (14) verbunden ist, wobei der Ausgang des Verstärkers (37) einen zweiten Ausgang des Differentialintegrators (20) bildet.

12. Anordnung nach einem der Ansprüche 1 bis 9, dadurch gekennzeichnet, dass die Anordnung zum Integrieren der Flächen der Impulse und Impulslücken einen ersten Operationsverstärker (25), einen zweiten Operationsverstärker (25a) und zwei Kondensatoren (26, 27) enthält, wobei die Ausgänge der beiden Operationsverstärker (25, 25a) die Ausgänge der Anordnung zum Integrieren der Flächen sind, dass ein Widerstandspaar (28a;29a bzw. 28b;29b bzw. 28c;29c) pro Phase vorhanden ist, wobei erste Pole der Widerstände (28a, 29a, 28b, 29b, 28c und 29c) eines jeden Widerstandspaares (28a;29a bzw. 28b;29b bzw. 28c;29c) mit den beiden Ausgängen des der betreffenden Phase zugehörigen Impulsamplituden-Modulators (14) verbunden sind, während jeweils ein zweiter Pol eines ersten Widerstandes (28a bzw. 28b bzw. 28c) eines jeden Widerstandspaares (28a;29a bzw. 28b;29b bzw. 28c;29c) mit einem invertierenden Eingang des ersten Operationsverstärkers (25) und ein zweiter Pol eines zweiten Widerstandes (29a bzw. 29b bzw. 29c) eines jeden Widerstandspaares (28a;29a bzw. 28b;29b bzw. 28c;29c) mit einem invertierenden Eingang des zweiten Operationsverstärkers (25a) verbunden ist, wobei jeweils einer der beiden Kondensatoren (26, 27) zwischen dem Ausgang und dem invertierenden Eingang eines der beiden Operationsverstärker (25 bzw. 25a) angeordnet ist, während die nichtinvertierende Eingänge der beiden Operationsverstärker (25, 25a) an Masse liegen.

13. Anordnung nach einem der Ansprüche 1 bis 9, dadurch gekennzeichnet, dass die Anordnung zum Integrieren der Flächen der Impulse und Impulslücken einen ersten Kondensator (26) und einen zweiten Kondensator (27) enthält, deren erste Pole beide an Masse liegen und deren zweite Pole die Ausgänge der Anordnung zum Integrieren der Flächen sind, dass ein Widerstandspaar (28a;29a bzw. 28b;29b bzw. 28c;29c) und zwei zugehörige Schaltkontakte pro Phase vorhanden sind, wobei erste Pole der Widerstände (28a, 29a, 28b, 29b, 28c und 29c) eines jeden Widerstandspaares (28a;29a bzw. 28b;29b bzw. 28c;29c) mit den beiden Ausgängen des der betreffenden Phase zugehörigen Impulsamplituden-Modulators (14) verbunden sind, während jeweils ein zweiter Pol eines ersten Widerstandes (28a bzw. 28b bzw. 28c) eines jeden Widerstandspaares (28a;29a bzw. 28b;29b bzw. 28c;29c) über einen ersten der beiden zugehörigen Schaltkontakte mit einem zweiten Pol des ersten Kondensators (26) und ein zweiter Pol eines zweiten Widerstandes (29a bzw. 29b bzw. 29c) eines jeden Widerstandspaares (28a;29a bzw. 28b;29b bzw. 28c;29c) jeweils über einen zweiten der beiden zugehörigen Schaltkontakte mit einem zweiten Pol des zweiten Kondensators (27) verbunden ist.

14. Anordnung nach einem der Ansprüche 11 bis 13, dadurch gekennzeichnet, dass der Spannungseingang (18) der Anordnung jeweils über ein RC-Netzwerk (36) mit den beiden Ausgängen des Impulsampliuden-Modulators (14) verbunden ist.

15. Anordnung nach Anspruch 14, dadurch gekennzeichnet, dass das RC-Netzwerk (36) aus einem ersten Widerstand (38), einem ersten Kondensator (39), einem zweiten Widerstand (40) und einem zweiten Kondensator (41) besteht, dass sein Eingang gebildet ist durch miteinander verbundenen ersten Polen der beiden Widerstände (38, 40), dass erste Pole der beiden Kondensatoren (39, 41) an Masse liegen, dass die zweiten Pole des ersten Widerstandes (38) und des ersten Kondensators (39) miteinander verbunden sind und einen ersten Ausgang des RC-Netzwerkes (36) bilden, und dass die zweiten Pole des zweiten Widerstandes (40) und des zweiten Kondensators (41) ebenfalls miteinander verbunden sind und einen zweiten Ausgang des RC-Netzwerkes (36) bilden.

Fig. 1

# Fig. 2

# Fig. 3

# Fig. 4

# Fig. 5

Fig.6

EP 0 389 749 A2

Fig. 7

EP 0 389 749 A2

Fig. 8

EP 0 389 749 A2

# Fig. 9

# Fig. 10

CL1

CL2

CL3

CL4